Europäisches Patentamt

European Patent Office

Office européen des brevets

(11) Publication number: **0 457 311 A2**

# EUROPEAN PATENT APPLICATION

(21) Application number: 91107883.0

(51) Int. Cl.⁵: **G11C 16/04**

(22) Date of filing: 15.05.91

(30) Priority: 15.05.90 JP 124742/90

(43) Date of publication of application:
21.11.91 Bulletin 91/47

(84) Designated Contracting States:
DE FR GB

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Yahata, Masamitsu, Toshiba Daini**
**Wakakusa Ryo**
**4-6, Komukai-Nishi-Machi, Saiwai-ku**
**Kawasaki-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor memory cell.

(57) A semiconductor memory cell having: a semiconductor substrate (1) of a first conductivity type; a source region (2) and a drain region (3) formed on the surface of the semiconductor substrate, with a channel region (ch) being interposed therebetween; a floating gate (5) formed above a first region (WA) of the channel region (ch) near the drain region, with a first insulating film (4) being interposed between the floating gate and the channel region; a first control gate (7) formed above the floating gate (5), with a second insulating film (6) being interposed therebetween; and a second control gate (7a) formed above a second region (RA) of the channel region (ch) near the source region (2), with a third insulating film (8) being interposed between the second control gate and the channel region, the second control gate (7a) being electrically conductive with the first control gate (7), the first region (WA) of the channel region (ch) being made a layer of a second conductivity type, and the second region (RA) being made a layer of the first conductivity type.

FIG.3

## FIELD OF THE INVENTION

The present invention relates to a semiconductor memory cell, and more particularly to a memory cell suitable for use as a memory cell of a charge storage type semiconductor memory device (hereinafter called an EPROM) suitable for reading data at a high speed.

## BACKGROUND OF THE INVENTION

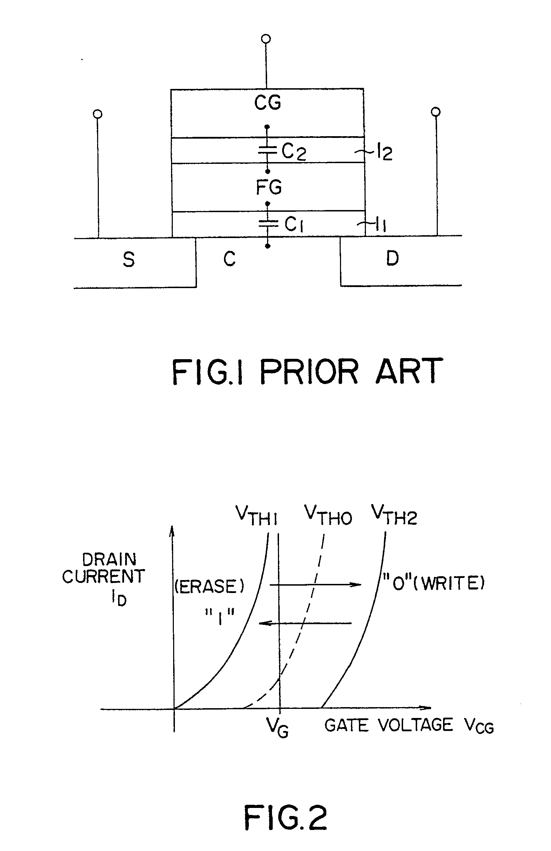

Fig. 1 is a cross sectional view showing a memory cell of a conventional semiconductor memory device (EPROM). As shown in Fig. 1, a floating gate FG and a control gate CG are formed above a channel C between a source S and a drain D, with insulating films 11 and 12 being interposed respectively between the channel and the floating gate and between the floating gate and the control gate. A capacitive component C2 is present between the control gate CG and the floating gate FG, and a capacitive component C1 is present between the floating gate FG and the substrate.

Data "1" and "0" stored in such an EPROM are discriminated by a threshold voltage determined depending upon whether or not electric charges are stored in the floating gate FG. Namely, if electric charges (electrons) are not stored in the floating gate FG, it is determined that data "1" is being stored. In this case, the threshold voltage takes a first value (which is smaller than a second value described later). If a high voltage is applied between the drain D and the control gate CG, hot electrons are generated which are then injected and stored in the floating gate FG. The threshold voltage therefore takes the second value larger than the first value. Namely, the threshold voltage becomes large. This state (state that information is being written) is considered that data "0" is being stored.

Consider that a read gate voltage $V_G$ is applied to the control gate CG shown in Fig. 2. If the presence/absence or amount of a drain current $I_D$ obtained in this condition is detected with a sense amplifier (not shown), it is possible to read data. For example, a read gate voltage $V_G$ of a cell having data "1" (erased state) is larger than the threshold voltage $V_{TH1}$ so that a drain current $I_D$ will flow. This state is considered that the data "1" has been read. On the other hand, the read gate voltage $V_G$ of a cell having data "0" (write state) is smaller than the threshold voltage $V_{TH2}$ so that the drain current will not flow. This state is considered that the data "0" has been read.

A simple equation generally used for obtaining a drain current $I_D$ is given by:

$$I_D = \mu \, \frac{W}{L} \cdot \frac{\varepsilon_{OX}}{T_{OX}} \, (V_D - V_S)$$

$$\left\{ V_G - V_t - \tfrac{1}{2}(V_D + V_S) \right\} \qquad \ldots \, (1)$$

wherein $\mu$ represents a mobility, $\varepsilon_{OX}$ represents a dielectric constant, L represents a channel length, W represents a channel width, $T_{OX}$ represents a thickness of an insulating film, $V_t$ represents a gate inversion voltage, $V_D$ represents a drain voltage, $V_S$ represents a source voltage, and $V_G$ represents a gate voltage.

Conventionally, the above constants have been set to optimum values in accordance with the cell write characteristics, reliability, and the like. The gate has a two-layered structure of a control gate CG and a floating gate FG. Therefore, a read voltage applied to the control gate CG is divided by the capacitive components C1 and C2. Furthermore, the gate inversion voltage $V_t$ is restricted by the write characteristics.

Apart from the above, for example, if ultraviolet light is applied, electric charges in the floating gate FG are supplied with energy sufficient for the charges to go over the energy barrier of the insulating films surrounding the floating gate FG. By discharging the electric charges from the floating gate, it is possible to change a write state "0" to an erased state "1".

With the advent of high speed processors such as microcomputers, a high speed response has been recently required also for semiconductor devices such as EPROMs. One of factors determining a read speed of an EPROM is a value of a drain current $I_D$ of a cell in a "1" state. In reading a cell in a "1" state, the drain current $I_D$ is detected with a sense amplifier (not shown). Specifically, the sense amplifier judges as "1" when the drain current $I_D$ takes a certain value after gradually increasing its value. Therefore, the larger the drain current $I_D$ becomes to flow through the cell in a "1" state at the time of reading data, the faster the sense amplifier responds, providing a high speed operation.

With a conventional two-layered cell, data read/write is performed using a single channel. In addition, this channel is positioned under the floating gate FG. There arise therefore the following problems. Namely, if the impurity concentration of boron B within the channel is made high in order to suppress the short channel effect which adversely affects the write characteristics, the drain current $I_D$ to be read lowers. Furthermore, a cell has a two-layered structure so that the gate voltage $V_G$ applied to the control gate CG is divided by the capacitive components C1 and C2. As compared with a cell having a single-layer structure and the same size, not only formation of a channel becomes slow but also the voltage serving to form the channel lowers, resulting in a smaller current $I_D$.

With a conventional cell having a two-layered structure, data read/write is performed with respect to the same and single channel under the floating gate FG. For this reason, there are more factors restricting the drain current $I_D$ than a transistor having a single layer structure, thereby hindering a high speed read operation.

## SUMMARY OF THE INVENTION

The present invention has been made in consideration of the above-described problems. It is an object of the present invention to provide a semiconductor memory cell of a charge storage type capable of reading stored data, particularly data "1", at a high speed.

According to one aspect of the present invention, there is provided a semiconductor memory cell comprising:

a semiconductor substrate of a first conductivity type;

a source region and a drain region formed on the surface of the semiconductor substrate, with a channel region being interposed therebetween;

a floating gate formed above a first region of the channel region near the drain region, with a first insulating film being interposed between the floating gate and the channel region;

a first control gate formed above the floating gate, with a second insulating film being interposed therebetween; and

a second control gate formed above a second region of the channel region near the source region, with a third insulating film being interposed between the second control gate and the channel region, the second control gate being electrically conductive with the first control gate,

the first region of the channel region being made a layer of a second conductivity type, and the second region being made a layer of the first conductivity type.

## BRIEF DESCRIPTION OF THE DRAWINGS

Fig. 1 is a cross sectional view showing a part of a memory cell of a conventional semiconductor memory device;

Fig. 2 is a graph showing the characteristics of the cell shown in Fig. 1; and

Figs. 3 and 4 are cross sectional views respectively showing parts of memory cells according to first and second embodiments of the present invention.

## DETAILED DESCRIPTION OF THE PREFERRED EMBODIMENTS

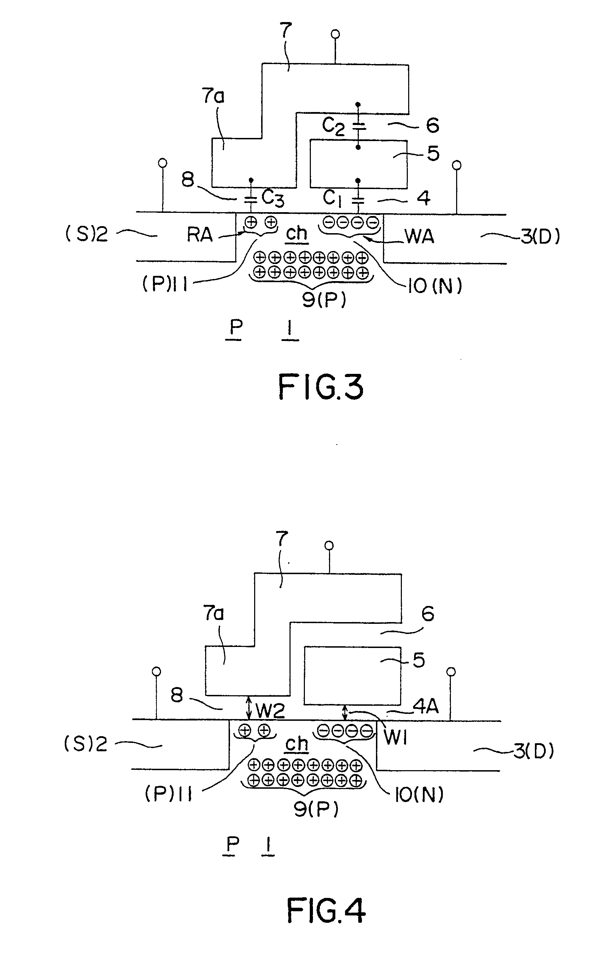

Fig. 3 is a cross sectional view showing the first embodiment of the present invention. In Fig. 3, a semiconductor substrate 1 is made of, e.g., P-type silicon. On the surface of the substrate 1, there are formed a source region 2 and a drain region 3 with a channel ch interposed therebetween, by means of ion implantation. A floating gate 5 made of, e.g., polysilicon is formed near the drain region 3 and above the channel ch, with a first insulating film 4 being interposed between the channel ch and the floating gate 5. A first control gate 7 made of, e.g., polysilicon is formed above the floating gate 5, with a second insulating film 6 being interposed therebetween. This first control gate 7 has a second control gate 7a formed near the source region 2 and above the channel ch, with a third insulating film 8 interposed between the channel ch and the second control gate 7a. The second control gate 7a constitutes a selection transistor.

At the deep area of the semiconductor substrate under the channel ch, there is formed a P-type high concentration region 9 which is formed by implanting boron (B) ions via an oxide film of about 150 Å, under the conditions, for example, at an acceleration voltage of 80 Kev and dose amount of about $1 \times 10^{13}$ cm$^{-2}$. Near the surface of the channel ch and under the first insulating film 4, there is formed an N-type low concentration region 10 which is formed by implanting arsenic (As) ions via an oxide film of about 150 Å, under the conditions, for example, at an acceleration voltage of 80 Kev and dose amount of about $1 \times 10^{12}$ cm$^{-2}$. The concentration of the N-type region 10 is set to about such a value which allows the formation of a P-type inversion layer when electric charges (electrons) are accumulated in the floating gate 5. Near the surface of the channel ch and under the third insulating film 8, there is formed a P-type low concentration region 11 which is formed by implanting boron (B) ions via an oxide film of about 150 Å, under the conditions, for example, at an acceleration voltage of 40 Kev and dose amount of about $2 \times 10^{12}$ cm$^{-2}$. The first insulating film 4 has a capacitive component C1, the second insulating film 6 has a capacitive component C2, and the third insulating film 8 has a capacitive component C3.

With the memory cell constructed as above, data write is performed by avalanche injection of hot electrons similar to the case shown in Fig. 1. When data is read from a cell in a '1' state (erased state), the channel under the floating gate 5 becomes of a depletion type (D-type). As a result, the drain current $I_D$ flowing through the channel is determined by the read portion 7a of the control gate 7. Thus, the read gate voltage $V_{CG}$ applied to the control gate 7 is applied to the channel via the capacitive component C3 without being voltage-divided.

A write region WA near the first insulating film 4 and a read region RA near the third insulating film 8 are separately formed in this embodiment. As a result, the surface concentration of the P-type low concentration region 11 of the read region RA can be made low irrespective of the write region, thereby allowing to increase the drain current $I_D$. For a cell having data "0" written, the N-type low concentration region 10 under the floating gate 5 is inverted to a P-type. Therefore, the threshold level of the "0" cell becomes larger than that of a "1" cell. It becomes possible therefore to distinguishably read data "1" and "0".

The cell shown in Fig. 3 is manufactured in the following way. Namely, ions are implanted to sequentially form the P-type high concentration region 9, P-type low concentration region 11, and N-type low concentration region 10. Next, the floating gate 5 and control gates 7 and 7a are formed. Lastly, using these gates as masks, ions and implanted to form the drain region 3, and source region 2.

The length of the D-type region under the floating gate 5 as measured from the drain 3 is set such that the pinch-off point of the channel in a data writing state reaches near under the floating gate 5 on the side of the source region 2. With such an arrangement, data write is possible in the conventional manner.

In the above embodiment, data write has been described using avalanche injection of electrons by way of example. Instead, as shown in Fig. 4, as a first insulating film 4A, a thin tunnel oxide film may be used to inject electrons into the floating gate 5 by means of the tunnel effect. For example, the thickness W1 of the first insulating film 4A may be 10 nm and the thickness W2 of the third insulating film 8 may be 20 nm.

Reference signs in the claims are intended for better understanding and shall not limit the scope.

## Claims

1. A semiconductor memory cell comprising:
    a semiconductor substrate (1) of a first conductivity type;
    a source region (2) and a drain region (3) formed on the surface of said semiconductor substrate, with a channel region (ch) being interposed therebetween;
    a floating gate (5) formed above a first region (WA) of said channel region (ch) near said drain region, with a first insulating film (4) being interposed between said floating gate and said channel region;
    a first control gate (7) formed above said floating gate (5), with a second insulating film (6) being interposed therebetween; and
    a second control gate (7a) formed above a second region (RA) of said channel region (ch) near said source region (2), with a third insulating film (8) being interposed between said second control gate and said channel region, said second control gate (7a) being electrically conductive with said first control gate (7),
    said first region (WA) of said channel region (ch) being made a layer of a second conductivity type, and said second region (RA) being made a layer of said first conductivity type..

2. A semiconductor memory cell according to claim 1, wherein the impurity concentration of said first region (WA) is set to such a value allowing an inversion to said first conductivity type when electric charges are accumulated in said floating gate (5).

3. A semiconductor memory cell according to claim 2, wherein a layer (9) under said channel region (ch) is made a high concentration layer of said first conductivity type.

4. A semiconductor memory cell according to claim 1, 2 or 3, wherein said first and second control gates (7, 7a) are formed integrally.

5. A semiconductor memory cell according to claim 3 or 4, wherein the impurity concentration of said second region (RA) is determined irrespective of the impurity concentration of said first region (WA), and determined lower than the impurity concentration of said layer (9) under said channel region.

6. A semiconductor memory cell according to claim 1, 3 or 5, wherein the thickness of said first insulating film (4) is set such that hot electrons generated within said semiconductor substrate (1) are avalanche-injected into said floating gate (5).

7. A semiconductor memory cell according to claim 1, 3 or 5, wherein the thickness of said first insulating film (4A) is set such that electrons within said semiconductor substrate (1) are injected into said floating gate (5) by a tunnel effect.

8. A semiconductor memory cell according to claim 7, wherein the thickness of said first insulating film (4A) is thinner than that of said third insulating film (8).

# FIG.1 PRIOR ART

# FIG.2

EP 0 457 311 A2

**FIG.3**

**FIG.4**